# EUROPEAN PATENT APPLICATION

(11) **EP 2 674 508 A1**
(43) Date of publication of application: **18.12.2013**
(21) Application number: 12744227.5
(22) Date of filing: 25.01.2012
(51) Int. Cl.: C23C 14/02, B32B 15/08, B32B 15/088, B32B 37/00, C23C 14/14, H05K 1/09

(54) **TWO-LAYERED COPPER-CLAD LAMINATE MATERIAL, AND METHOD FOR PRODUCING SAME**

(30) Priority: 10.02.2011 JP 2011027099
(71) Applicant: JX Nippon Mining & Metals Corporation, Tokyo 100-8164 (JP)
(72) Inventor: INAZUMI Hajime, Hitachi-city, Ibaraki 317-0056 (JP); SASAKI Shinichi, Hitachi-city, Ibaraki 317-0056 (JP)
(74) Representative: Hoarton, Lloyd Douglas Charles
(86) International application number: PCT/JP2012/051549
(87) International publication number: WO 2012/108264

(57) **Abstract**

A two-layered copper-clad laminate material in which a copper layer having a thickness of 1 to 5 µm is formed by means of sputtering or electroplating on one surface or both surfaces of a polyimide film having a thickness of 12.5 to 50 µm after a plasma treatment is performed in a nitrogen gas atmosphere, the two-layered copper-clad laminate material being characterized in that the dissolution of the aforementioned polyimide film with an etching liquid is delayed compared with a polyimide film that is not subjected to the plasma treatment, the aforementioned dissolution being delayed as a consequence of reforming the surface of the polyimide film by incorporating nitrogen into the polyimide film by means of the plasma treatment in the nitrogen gas atmosphere. The present invention addresses the problem of obtaining a two-layered copper-clad laminate material (plate) which exerts excellent adhesive properties and adhesive properties after thermal aging, and does delaminate when dry etching a polyimide film, at which point the dissolution properties of the polyimide film is delayed (the polyimide film does not dissolve) compared with an untreated polyimide film.

## Description

### TECHNICAL FIELD

The present invention relates to: a two-layered copper-clad laminate material, in which a copper layer is formed by sputtering or plating on a polyimide film, which maintains an excellent thermal peel strength, and in which the etching rate of the polyimide film by an etching solution (TP-3000 manufactured by Toray engineering) is delayed; and a method for producing the same.

### BACKGROUND ART

Lately, flexible circuit boards have been used for various purposes, and the demand characteristics vary depending on the various applications. Two-layered copper-clad laminate (CCL: Cu Clad Laminate) material in which a copper layer is formed on a polyimide film (PI), a material for flexible circuit boards, is characterized by the ability to form a copper layer of no more than 5 µm thick, as well as by the flexibility in designing the thickness of the film, in comparison to cast materials.

The thickness of the copper layer required in applications such as medical probes and gas electron multipliers is 2 to 5 µm. For these applications, one-sided or two-sided CCL having polyimide film thickness of 12.5 to 50 µm is desirable.

In the two-layered CCL material manufactured by sputtering or plating method, the copper layer is produced by forming a copper layer having a submicron thickness on a polyimide film by sputtering, followed by plating treatment using copper sulfate. The invention for this process in its basic form is disclosed in the Patent Document 1 described below.
The production steps of CCL for such applications include copper layer etching step, press step, polyimide film etching step and the like.

Among these steps, the polyimide film etching step is especially important since through-holes and flying leads are formed during this step, thereby making flexible circuit design possible.
The polyimide film etching step can broadly be categorized into two types; the wet process using an etching solution and the dry process using laser or ion irradiation.
The dry process, in particular, is advantageous in that it allows finer processing in comparison to the wet process and the finished surface after the processing to be better.

However, in the dry process, if there is not enough adhesion between the copper layer and the polyimide film, the localized irradiation of laser or ion can cause the copper layer and the polyimide film to separate during the production process, and adversely affect the subsequent steps. When the separation is severe, the entire production process itself becomes impossible.

As one of the method for increasing the adhesiveness between the copper layer and the polyimide film, a method in which the thickness of the tie-coat layer, such as NiCr, between the copper layer and the polyimide film is increased to about 25 nm, is proposed for COF (Chip on film) application.
However, the thickness of the tie-coat layer needs to be no more than 10 nm thick, from the point of view of etching for applications in medical probes and gas electron multipliers.

On the other hand, as disclosed in Patent Document 2, the functionality of the tie-coat layer as a barrier is not sufficient when the thickness of the tie-coat layer is only about 10 nm. In addition, for COF (Chip on film) application, a tie-coat layer having about 25 nm of thickness is thought to be required, from the viewpoint of not only of adhesiveness but also of insulation reliability in fine-pitched circuits.

Plasma treatment is a generally performed method for improving adhesiveness between a copper layer and a polyimide film. There are numerous reports as to its effectiveness (see Patent Document 3).
However, the effectiveness of reformation by plasma treatment varies greatly depending on the format of electric discharge and the types of gas used. For example, Patent Document 3 discloses that "the content ratio of nitrogen of the polyimide used before the reformation treatment was 6.4 at% or less, and this is the maximum value".

In addition, the nitrogen content of the polyimide film before the reformation treatment is set at 6.4 at%, which is the nitrogen content specified in the Patent Document 3. This amount differs greatly from that of the present invention as described below. This difference is most likely due to the difference in the type of the polyimide film. As described below, it is important to perform the plasma treatment such that the nitrogen content after the reformation treatment would be higher than the nitrogen content prior to the reformation treatment.

As described above, in CCL applications for medical probes and gas electron multipliers, the thickness of the tie-coat layer is 10 nm or less. Therefore, there is a need to examine ways of improving the adhesiveness by the plasma treatment.

Patent Document 1: US Patent No. 5685970
Patent Document 2: WO2008/114539
Patent Document 3: Japanese Laid-Open Patent Publication No. 2008-78276

### SUMMARY OF INVENTION

### [Technical Problem]

The present invention aims at obtaining a two-layered copper-clad laminate material (CCL material) in which a copper layer is formed on a polyimide film by sputtering and plating treatments, especially a two-layered copper-clad laminate material (plate) having a copper layer thickness of 5 µm or less and a polyimide film thickness of 12.5 to 50 µm, which exhibits excellent adhesive properties as well as excellent adhesive properties after thermal aging, does not delaminate during the dry etching process of the polyimide film, and delays the dissolvability of the polyimide film (in other words, resists dissolving) compared to untreated polyimide film.

### [Solution to Problem]

After diligently investigating in order to resolve the above-mentioned problems, the inventors have discovered a condition for plasma treatment in which excellent adhesive properties can still be obtained even with a thin tie-coat layer of no more than 10 nm thick, in a two-layered copper-clad laminate material wherein a copper layer is formed on a polyimide film by sputtering and plating treatment.

Based on these discoveries, the present invention provides:
1) a two-layered copper-clad laminate material characterized by subjecting one surface or both surfaces of a polyimide film having a thickness of 12.5 to 50 µm to a plasma treatment in a nitrogen gas atmosphere, followed by incorporating nitrogen in the polyimide film by means of sputtering or electroplating via a plasma treatment in a gas atmosphere to reform the surface of the polyimide film, and thereby delaying the dissolution of the polyimide film with an etching solution compared with a polyimide film that is not subjected to the plasma treatment.

In addition, the present invention provides:
2) a two-layered copper-clad laminate material in which a copper layer having a thickness of 1 to 5 µm is formed by means of sputtering or electroplating after plasma-treating one surface or both surfaces of a polyimide film having a thickness of 12.5 to 50 µm in a nitrogen gas atmosphere, characterized by incorporating an increased amount of nitrogen in the surface of the polyimide film subjected to a plasma treatment compared with the through-thickness center region, where the plasma treatment does not affect, of the polyimide film.

In addition, the present invention provides:
3) the two-layered copper-clad laminate material according to 1) above, characterized by reforming the surface of the polyimide film to inhibit hydrolysis;
4) the two-layered copper-clad laminate material according to any one of 1) to 3) above, characterized by forming a tie-coat layer comprising Ni, Cr, Ni-Cu alloy or Ni-Cr alloy on the polyimide film by means of sputtering, prior to forming a copper layer on one surface or both surfaces of the polyimide film; and
5) the two-layered copper-clad laminate material according to any one of 1) to 4) above, characterized by having a normal state peel strength of 0.90 kN/m or more and a thermal peel strength of 0.70 kN/m or more, when the thickness of the tie-coat layer is 10 nm or less.

In addition, the present invention provides:
6) a production method for a two-layered copper-clad laminate material in which a copper layer having a thickness of 1 to 5 µm is formed by means of sputtering or electroplating after plasma-treating one surface or both surfaces of a polyimide film having a thickness of 12.5 to 50 µm in a nitrogen gas atmosphere, characterized by incorporating nitrogen in the polyimide film by means of a plasma treatment in a nitrogen gas atmosphere to reform the surface of the polyimide film, and thereby delaying the dissolution of the polyimide film with an etching solution compared with a polyimide film not subjected to the plasma treatment.

In addition, the present invention provides:
7) a production method for a two-layered copper-clad laminate material in which a copper layer having a thickness of 1 to 5 µm is formed by means of sputtering or plating after plasma-treating one surface or both surfaces of a polyimide film having a thickness of 12.5 to 50 µm in a nitrogen gas atmosphere, characterized by incorporating an increased amount of nitrogen in the surface of the polyimide film subjected to a plasma treatment compared with the through-thickness center region, where the plasma treatment does not affect, of the polyimide film.

In addition, the present invention provides:
8) the production method for the two-layered copper-clad laminate material according to 6) above, characterized by reforming the surface of the polyimide film to inhibit hydrolysis;
9) the production method for the two-layered copper-clad laminate material according to any one of 6) to 8) above, characterized by forming a tie-coat layer comprising Ni, Cr, Ni-Cu alloy or Ni-Cr alloy on the polyimide film by means of sputtering, prior to forming a copper layer on one surface or both surfaces of the polyimide film; and
10) the production method for the two-layered copper-clad laminate material according to any one of 6) to 9) above, characterized by providing a normal state peel strength of 0.90 kN/m or more and a thermal peel strength of 0.70 kN/m or more, when the thickness of the tie-coat layer is 10 nm or less.

### [Effects of Invention]

The two-layered copper-clad laminate material of the present invention exhibits such the excellent adhesive properties that the normal state peel strength is 0.9 kN/m or more and the thermal peel strength is 0.7 kN/m or more, even when the thickness of the tie-coat layer is 10 nm or less, in the two-layered copper-clad laminate material (CCL material) in which a copper layer is formed on a polyimide film by means of sputtering and plating treatments, and especially in the two-layered copper-clad laminate material (plate) in which a copper layer having a thickness of 5 µm or less is formed on one surface or both surfaces of the polyimide film having a thickness of 12.5 to 50 µm. For this reason, the present invention imparts excellent advantageous effect of providing CCL that is free from the peeling problems encountered during the dry etching step of polyimide film without compromising the etching property, for such applications as medical probes, gas electron multipliers and the like.

### DESCRIPTION OF EMBODIMENTS

### (Regarding the processing step of polyimide (PI) film)

The production process of a copper-clad laminated plate includes a processing step of polyimide (PI) film. This step is performed when making holes (through holes) in the PI film or forming flying leads. This step involves removing unnecessary PI film. There are two kinds of method for the PI film processing step (in other words, method for removing PI), namely, wet treatment and dry treatment.

In dry processing, laser or ion are irradiated on the PI film to be processed. In this method, the unnecessary part is either burned off by laser or removed by sputtering. The part to be processed is locally heated not only in the case of laser irradiation, but also in the case of ion irradiation. In the dry processing, the adhesiveness between the resin and copper is important. When the adhesiveness is not good enough, the resin and copper may separate, making the processing very difficult.

The dry processing costs more but the finished surface after the processing will be better. For example, in a process that involves opening a hole, it is impossible to form a completely perpendicular hole by wet processing due to the inevitable occurrence of sagging. In contrast, in dry processing, forming a completely perpendicular hole without the occurrence of sagging is possible. Furthermore, much finer processing is possible in dry processing than in wet processing.

### (PI film processing step and PI film surface treatment step)

The PI film surface treatment step performed during the production of the copper-clad laminate plate is an essential step for improving the adhesiveness between the PI film and the copper layer. When the adhesiveness between the PI and copper layer is not good enough, problems during the processing such as circuit loss during etching of the copper layer, in addition to problems after the formation of the circuit such as deterioration of long-term reliability, can arise.

Surface treatment of the PI film results in a change of PI film proximal to the surface, such as a change in the composition ratio and the state of chemical bond in the surface. The manner of the changes can vary greatly depending on the methods utilized for treating the surface. Therefore it is necessary to study, in detail, the relationship between the change associated with the surface treatment of PI film and the processing steps of the PI film and to produce a PI film having the most adequately improved surface.

In the dry processing of the PI film, the boundary between the PI film and the copper layer has to be heat resistant, because as described earlier, a localized heat burden is applied during the processing. In other words, it is important that the copper-clad laminate plate exhibits high thermal peel strength. The copper-clad laminate plate exhibiting high heat resistance and adhesiveness is characterized by having an increased nitrogen content after the surface treatment step of the PI film. The present invention provides a two-layered copper-clad laminate material suitable for the dry removal processing of the PI film.

The surface of polyimide film placed in a vacuum chamber is activated by plasma treatment. A copper layer of about submicron thickness is then formed by sputtering.
The copper layer thus formed is called a copper seed layer since it will function as the seed for the electrolytic copper layer that is formed in a later step. Prior to forming a copper layer of an about submicron by sputtering, it is also possible to form a tie-coat layer comprising Ni, Cr, Ni-Cu alloy or Ni-Cr alloy by sputtering on the surface of the polyimide film.

As described earlier, for applications in medical probes and gas electron multipliers, the thickness of the tie-coat layer cannot be more than 10 nm, from the viewpoint of etching property. For this reason, the plasma treatment of polyimide film surface was examined in detail. As the result, the following findings were made.

It is generally believed that subjecting a polyimide film to plasma treatment results in the formation of functional groups on the surface of the polyimide film. On the other hand, when there is a certain level of adhesive strength, the mode of peel separation is that of cohesive failure within the polyimide film, and reflects the strength of polyimide bulk (B) rather than the strength of the boundary between the polyimide film and the metal layer (A). It is of course possible to have a separation at the boundary of the polyimide film and the metal layer when A<B, however, in this case the peel strength is known to be much lower.

In the present invention, it was confirmed using photoelectron spectroscopy (XPS) that the nitrogen content can be increased from 15.9 at% before the reformation to 16.5 to 18.6 at% after the reformation, by optimizing the conditions for plasma treatment and reforming the polyimide film by electric discharge using an adequate electric power and nitrogen gas (see Table 1). This result is in conflict with that of Patent Document 3 described above. This would be one good example of the statement "the reformation by the plasma treatment varies greatly depending on the format of electric discharge and the types of gas used".

In the present invention, XPS analysis of the surface of the polyimide film before and after the plasma treatment was performed for surface characterization. In addition, the dissolvability of the polyimide film before and after the plasma treatment was evaluated, and as the result, the two-layered copper-clad plate that is optimum for the dry etching step of polyimide film and the production method thereof were developed.

Further, the deterioration of adhesive strength due to heating is caused by the dispersion of copper throughout the polyimide film, leading to the hydrolysis of the polyimide film. The hydrolysis of the polyimide film is thought to occur at the boundary of the polyimide film and the metal layer. In other words, the strength of A discussed above is thought to change due to heating, altering the magnitude relationship of A and B above. This in turn is thought to change the mode of peel separation.

Accordingly, in order to improve the thermal peel strength, it is necessary to prevent the hydrolysis at the boundary of the polyimide film and the metal layer. For this purpose, it is necessary to either block the dispersion of Cu or reform the surface of the polyimide film to a state that is not susceptible to hydrolysis.
In the this investigation, from the consideration for the etching property for applications in medical probes and gas electron multipliers as discussed above, the surface of the polyimide film was reformed so as to be in a state of the polyimide film that is not susceptible to hydrolysis. Specific examples are given in the Examples below. It was discovered that a surface of polyimide film that is not susceptible to hydrolysis can be formed by increasing the nitrogen content of the surface of the polyimide film.

The polyimide film of the present invention has a thickness of 12.5 to 50 µm. One surface or both surfaces of the polyimide film are subjected to plasma treatment, followed by the formation of copper layer having a thickness of 5 µm or less by means of sputtering or electroplating, for producing the two-layered copper-clad laminate material. Plasma glow treatment is then performed to increase the nitrogen content of the polyimide film. As the result of the above procedure, such the excellent adhesive properties that the normal peel strength is 0.9 kN/m or more and the thermal peel strength is 0.7 kN/m or more can be obtained, even under the condition where the thickness of the tie-coat layer is no more than 10 nm.

Plasma glow treatment is an electric discharge (glow discharge) phenomenon which occurs when voltage is applied between an anode and a cathode in the presence of low pressure gas (such as argon, nitrogen and oxygen), in which the rarefied gas is ionized and plasma comprising electrons and positive gas ions (for examples, argon ion, nitrogen ion, and the like) is generated. By exposing the polyimide film to plasma, the positive ions, electrons, and ultraviolet light in the plasma act on the surface of the polyimide film, thereby reforming it. This acting may involve absorption, desorption, and severing of molecular chains.

Glow discharge in the presence of nitrogen is the preferable method for the plasma treatment. However, as long as the treatment would reform the polyimide film so that its surface status would have the characteristics described in the Examples below, the surface treatment can be performed by other means such as ion irradiation, ultraviolet irradiation and the like.
Plasma treatment of the surface of a polyimide film results in an increase in the nitrogen content compared with a polyimide film not subjected to the plasma treatment. As shown in the Examples below, the effect of increasing normal peel strength and thermal peel strength can be obtained by the reformation of the surface of the polyimide film. Even a small amount of increase, such as 1% increase of nitrogen has an effect, compared with the untreated polyimide film.

Normally, around 5 to 20% increase of nitrogen content would result in the satisfactory increase of normal peel strength and thermal peel strength, and achieve the goal of the invention. However, there are no restrictions as to the content of nitrogen, and its amount can be set freely. Notably, since it is impossible to directly compare the nitrogen contents of the polyimide film subjected to the plasma treatment and the untreated polyimide film or the polyimide film prior to treatment in a two-layered copper-clad laminate material; the increase of nitrogen, in the present invention, was confirmed by comparing the surface of the polyimide film subjected to the plasma treatment, and the through-thickness center region, where the plasma treatment does not affect, of the polyimide film.
Thus, the nitrogen content of the surface of the polyimide film exposed after removing the copper layer of the two-layered copper-clad laminate material, was measured first. Then, the nitrogen content was measured again after removing half of the depth of the polyimide film. The contents were obtained from the photoelectric spectrum after analyzing the surface with XPS.

A two-layered CCL, having such the excellent adhesive properties that the normal peel strength is 0.8 kN/m or more and the thermal peel strength is 0.7 kN/m or more even under the condition where the thickness of tie-coat layer is 10 nm or less, and exhibiting a delayed etching rate of the polyimide film by the etching solution (TP-3000 manufactured by Toray Engineering), is thus obtained.
The polyimide film used for the two-layered CCL material of the present invention, is not especially restricted as long as it can achieve the goal of the present invention. However, preferably, it is effective to use BPDA-PPD based polyimide film.

### [Examples]

The features of the present invention are specifically described below. The explanation is given to facilitate the understanding of the present invention, and not to limit it in any way. In other words, any transformations, embodiments and other examples based on the technological thought of the present invention are thought to be encompassed by the present invention.

### (Example 1)

A copper layer having a thickness of 5 µm was prepared by performing plasma treatment, sputtering and plating treatment, using a polyimide film having a thickness of 25 µm (Kapton manufactured by Toray-Dupont).
For the plasma treatment, plasma glow treatment was performed using the glow discharge of nitrogen gas under the following condition. The gas pressure was at 9 Pa and the standard treatment intensity (glow treatment intensity) was 1. Subsequently, 10 nm of a NiCr (20 wt%) tie-coat layer and 20 nm of a copper seed layer were formed by sputtering, and 18 µm of a copper layer was formed by electroplating.

The two-layered CCL thus formed was further subjected to electroplating to make the thickness of the copper layer 18 µm, and circuits having a width of 3 mm were formed. Peel strength was then measured using 90°C method. Additionally, after 168 hours of heating at 150 °C, the peel strength was measured. The reason for having a copper layer with a thickness of 18 µm is to facilitate the measurement of peel strength.

The surface of the polyimide film after the plasma treatment was analyzed by XPS, and the nitrogen content was obtained from the photoelectric spectrum. Further, the metal layer of the two-layered CCL thus produced was completely removed by a mixture of ferric chloride and hydrochloric acid and it was subjected to washing with water to recover the naked polyimide film. The recovered polyimide film was submerged in TP-3000 at a solution temperature of 50 °C, and the time required for complete dissolution was measured. The results are shown in Table 1.

**[Table 1]**

| | Gas for Glow Treatment | GL Treatment Intensity | Nitrogen Content (at%) | Rate of Increase in Nitrogen Content | Time for Complete PI Dissolution (min) | Tie-coat Layer Composition | Tie-coat Layer Thickness (nm) | Normal State Peel Strength (kN/m) | Thermal Peel Strength (kN/m) |
|---|---|---|---|---|---|---|---|---|---|
| Example 1 | Nitrogen | 1.0 | 18.5 | 116.4 | 14 | Ni-Cr(20wt%) | 10 | 1.00 | 0.83 |
| Example 2 | Nitrogen | 0.5 | 16.6 | 104.4 | 12 | Ni-Cr(20wt%) | 10 | 0.90 | 0.75 |
| Example 3 | Nitrogen | 1.0 | 18.0 | 113.2 | 14 | Cr | 7 | 1.07 | 0.80 |
| Example 4 | Nitrogen | 0.5 | 17.2 | 108.2 | 12 | Cr | 7 | 1.10 | 0.73 |
| Comparative Example 1 | Untreated | 0.0 | 15.9 | 100.0 | 6 | Ni-Cr(20wt%) | 10 | 0.70 | 0.30 |
| Comparative Example 2 | Oxygen | 1.0 | 4.0 | 25.2 | 6 | Ni-Cr(20wt%) | 10 | 1.00 | 0.61 |
| Comparative Example 3 | Oxygen | 0.5 | 5.9 | 37.1 | 6 | Ni-Cr(20wt%) | 10 | 0.96 | 0.56 |
| Comparative Example 4 | Oxygen | 1.0 | 4.2 | 26.4 | 6 | Cr | 7 | 0.93 | 0.60 |
| Comparative Example 5 | Oxygen | 0.5 | 6.0 | 37.7 | 6 | Cr | 7 | 1.00 | 0.55 |

The results show the nitrogen content of the polyimide film of 18.5 at%, time for complete dissolution of the polyimide film of 14 min, normal peel strength of 1.00 kN/m, and thermal peel strength of 0.83 kN/m. As can be seen, an increase in the nitrogen content of the polyimide film suppressed the hydrolysis of the polyimide film, thereby elongating the dissolution time and allowing one to obtain a stable polyimide film. In addition, an excellent result of increases in normal peel strength as well as thermal peel strength was also observed.

### (Example 2)

In Example 2, the identical procedure as in Example 1 was followed except for setting the standard treatment intensity of plasma treatment (glow treatment intensity) to 0.5. The results are likewise shown in Table 1.
As can be seen in Table 1, the nitrogen content of the polyimide film was 16.6 at%, time for complete dissolution of the polyimide film was 12 min, normal peel strength was 0.90 kN/m, and thermal peel strength was 0.75 kN/m.

As can be seen, an increase in the nitrogen content of the polyimide film suppressed the hydrolysis of the polyimide film, thereby elongating the dissolution time and allowing one to obtain a stable polyimide film. In addition, an excellent result of increases in normal peel strength as well as thermal peel strength was also observed.

### (Example 3)

In Example 3, the identical procedure as in Example 1 was followed except for changing the composition of the tie-coat layer formed by sputtering to Cr, and setting the thickness of the layer to 7 nm. The results are likewise shown in Table 1.
As can be seen in Table 1, the nitrogen content of the polyimide film was 18.0 at%, time for complete dissolution of the polyimide film was 14 min, normal peel strength was 1.07 kN/m, and thermal peel strength was 0.80 kN/m.

As can be seen, an increase in the nitrogen content of the polyimide film suppressed the hydrolysis of the polyimide film, thereby elongating the dissolution time and allowing one to obtain a stable polyimide film. In addition, an excellent result of increases in normal peel strength as well as thermal peel strength was also observed.

### (Example 4)

In Example 4, the identical procedure as in Example 3 was followed except for changing the standard treatment intensity of plasma treatment to 0.5. The results are likewise shown in Table 1.
As can be seen in Table 1, the nitrogen content of the polyimide film was 17.2 at%, time for complete dissolution of the polyimide film was 12 min, normal peel strength was 1.10 kN/m, and thermal peel strength was 0.73 kN/m.

As can be seen, an increase in the nitrogen content of the polyimide film suppressed the hydrolysis of the polyimide film, thereby elongating the dissolution time and allowing one to obtain a stable polyimide film. In addition, an excellent result of increases in normal peel strength as well as thermal peel strength was also observed.

### (Comparative Example 1)

In Comparative Example 1, the identical procedure as in Example 1 was followed except for not performing the plasma treatment (untreated). The results are likewise shown in Table 1.
As can be seen in Table 1, the nitrogen content of the polyimide film was 15.9 at%, time for complete dissolution of the polyimide film was 6 min, normal peel strength was 0.70 kN/m, and thermal peel strength was 0.30 kN/m.

Thus, when the plasma treatment is not performed, normal peel strength and thermal peel strength were both significantly lower, making the product not suitable as the two-layered copper-clad laminate material. This suggests that adequate adhesiveness cannot be achieved with the original nitrogen level contained in the polyimide film, due to problems such as insufficient amount, the status of chemical bond and the like.

### (Comparative Example 2)

In Comparative Example 2, the identical procedure as in Example 1 was followed except for changing the gas used in the plasma treatment to oxygen. The results are likewise shown in Table 1.
As can be seen in Table 1, the nitrogen content of the polyimide film was 4.0 at%, time for complete dissolution of the polyimide film was 6 min, normal peel strength was 1.00 kN/m, and thermal peel strength was 0.61 kN/m.

As seen above, the nitrogen content of the polyimide film was significantly lowered, promoting the hydrolysis of the polyimide film. As the result, the dissolution time was shortened and the stability of the polyimide film was lost. In addition, thermal peel strength deteriorated, making the product unsuitable as the two-layered copper-clad laminate material.

### (Comparative Example 3)

In Comparative Example 3, the identical procedure as in Comparative Example 2 was followed except for changing the standard treatment intensity of plasma treatment (glow treatment intensity) to 0.5. The results are likewise shown in Table 1.
As can be seen in Table 1, the nitrogen content of the polyimide film was 5.9 at%, time for complete dissolution of the polyimide film was 6 min, normal peel strength was 0.96 kN/m, and thermal peel strength was 0.56 kN/m.

As seen above, the nitrogen content of the polyimide film was significantly lowered, promoting the hydrolysis of the polyimide film. As the result, the dissolution time was shortened and the stability of the polyimide film was lost. In addition, thermal peel strength deteriorated, making the product unsuitable as the two-layered copper-clad laminate material.

### (Comparative Example 4)

In Comparative Example 4, the identical procedure as in Comparative Example 3 was followed except for changing the composition of the tie-coat layer formed by sputtering to Cr and setting the thickness of the layer to 7 nm. The results are likewise shown in Table 1.
As can be seen in Table 1, the nitrogen content of the polyimide film was 4.2 at%, time for complete dissolution of the polyimide film was 6 min, normal peel strength was 0.93 kN/m, and thermal peel strength was 0.60 kN/m.

As seen above, the nitrogen content of the polyimide film was significantly lowered, promoting the hydrolysis of the polyimide film. As the result, the dissolution time was shortened and the stability of the polyimide film was lost. In addition, thermal peel strength deteriorated, making the product unsuitable as the two-layered copper-clad laminate material.

### (Comparative Example 5)

In Comparative Example 5, the identical procedure as in Comparative Example 4 was followed except for changing the standard treatment intensity of plasma treatment (glow treatment intensity) to 0.5. The results are shown in Table 1.
As can be seen in Table 1, the nitrogen content of the polyimide film was 6.0 at%, time for complete dissolution of the polyimide film was 6 min, normal peel strength was 1.00 kN/m, and thermal peel strength was 0.55 kN/m.

As seen above, the nitrogen content of the polyimide film was significantly lowered, promoting the hydrolysis of the polyimide film. As the result, the dissolution time was shortened and the stability of the polyimide film was lost. In addition, thermal peel strength deteriorated, making the product unsuitable as the two-layered copper-clad laminate material.

In summary, each of the Examples exhibited excellent results. Thus, the nitrogen content of the surface of the polyimide film was increased compared with that not subjected to plasma treatment, and Examples 1 to 4 of the present invention all exhibited thermal peel strength of 0.7 kN/m or more. Moreover, the etching time of the polyimide film was also increased.

Since the dissolution of the polyimide film occurs by hydrolysis, the lengthening of the etching time of the polyimide film means that the polyimide film is reformed, by the plasma treatment, into a state that is less susceptible to hydrolysis.
Thus, performing the reformation of the surface to increase the nitrogen content of the surface of the polyimide film is clearly essential for obtaining excellent adhesive properties, even when the thickness of the tie-coat layer is 10 nm or less.

### INDUSTRIAL APPLICABILITY

In a two-layered copper-clad laminate material (CCL material) in which a copper layer is formed on a polyimide film by means of sputtering and plating treatment, and especially in a two-layered copper-clad laminate material (plate) comprising the copper layer having a thickness of 5 µm or less and the polyimide film having a thickness of 12.5 to 50 µm; the present invention exhibits a superior effect in achieving excellent adhesive properties as well as excellent adhesive properties after thermal aging, thereby reducing the problems encountered during the process of dry etching the polyimide film. Thus, the present invention is suitable for applications in various small electronic circuit boards, such as those used for medical probes and gas electron multipliers.

## Claims

1. A two-layered copper-clad laminate material in which a copper layer having a thickness of 1 to 5 µm is formed by means of sputtering or electroplating after plasma-treating one surface or both surfaces of a polyimide film having a thickness of 12.5 to 50 µm in a nitrogen gas atmosphere, **characterized by** incorporating nitrogen into the polyimide film by a plasma treatment in the nitrogen gas atmosphere to reform the surface of the polyimide film, and thereby delaying the dissolution of the polyimide film with an etching solution compared with a polyimide film that is not subjected to the plasma treatment.

2. A two-layered copper-clad laminate material in which a copper layer having a thickness of 1 to 5 µm is formed by means of sputtering or electroplating after plasma-treating one surface or both surfaces of a polyimide film having a thickness of 12.5 to 50 µm in a nitrogen gas atmosphere, **characterized by** incorporating an increased amount of nitrogen in the surface of the polyimide film subjected to a plasma treatment compared with the through-thickness center region, where the plasma treatment does not affect, of the polyimide film.

3. The two-layered copper-clad laminate material according to claim 1, **characterized by** reforming the surface of the polyimide film to inhibit hydrolysis.

4. The two-layered copper-clad laminate material according to any one of claims 1 to 3, **characterized by** forming a tie-coat layer comprising Ni, Cr, Ni-Cu alloy or Ni-Cr alloy on the polyimide film by means of sputtering, prior to forming a copper layer on one surface or both surfaces of the polyimide film.

5. The two-layered copper-clad laminate material according to any one of claims 1 to 4, **characterized by** having a normal state peel strength of 0.90 kN/m or more and a thermal peel strength of 0.70 kN/m or more, when the thickness of the tie-coat layer is 10 nm or less.

6. A production method for a two-layered copper-clad laminate material in which a copper layer having a thickness of 1 to 5 µm is formed by means of sputtering or electroplating after plasma-treating one surface or both surfaces of a polyimide film having a thickness of 12.5 to 50 µm in a nitrogen gas atmosphere, **characterized by** incorporating nitrogen in the polyimide film by means of a plasma treatment in a nitrogen gas atmosphere to reform the surface of the polyimide film, and thereby delaying the dissolution of the polyimide film with an etching solution compared with a polyimide film not subjected to the plasma treatment.

7. A production method for a two-layered copper-clad laminate material in which a copper layer having a thickness of 1 to 5 µm is formed by means of sputtering or electroplating after plasma-treating one surface or both surfaces of a polyimide film having a thickness of 12.5 to 50 µm in a nitrogen gas atmosphere, **characterized by** incorporating an increased amount of nitrogen in the surface of the polyimide film subjected to a plasma treatment compared with the through-thickness center region, where the plasma treatment does not affect, of the polyimide film.

8. The production method for the two-layered copper-clad laminate material according to claim 6, **characterized by** reforming the surface of the polyimide film to inhibit hydrolysis.

9. The production method for the two-layered copper-clad laminate material according to any one of claims 6 to 8, **characterized by** forming a tie-coat layer comprising Ni, Cr, Ni-Cu alloy or Ni-Cr alloy on the polyimide film by means of sputtering, prior to forming a copper layer on one surface or both surfaces of the polyimide film.

10. The production method for the two-layered copper-clad laminate material according to any one of claims 6 to 9, **characterized by** providing a normal state peel strength of 0.90 kN/m or more and a thermal peel strength of 0.70 kN/m or more, when the thickness of the tie-coat layer is 10 nm or less.
